# EUROPÄISCHE PATENTSCHRIFT

(11) **EP 0 464 232 B1**
(45) Veröffentlichungstag und Bekanntmachung des Hinweises auf die Patenterteilung: **16.03.1994**
(21) Anmeldenummer: 90112537.7
(22) Anmeldetag: 30.06.1990
(51) Int. Cl.: H01L 23/495, H01L 31/0203, H01R 4/02, H01R 9/09, H01R 11/01

(54) **Lötverbinder und Verfahren zur Herstellung einer elektrischen Schaltung mit diesem Lötverbinder**
Solder connector and process for making an electrical circuit with this solder connector
Connecteur de soudure et procédé de fabrication d'un circuit électrique avec ce connecteur de soudure

(43) Veröffentlichungstag der Anmeldung: 08.01.1992
(73) Patentinhaber: Dr. Johannes Heidenhain GmbH, D-83292 Traunreut (DE)
(72) Erfinder: Kraus, Heinz, D-8225 Traunreut (DE)

(56) Entgegenhaltungen:
- EP-A- 0 303 808
- DE-A- 1 490 080
- GB-A- 2 175 149
- US-A- 4 413 404
- PATENT ABSTRACTS OF JAPAN vol. 12, no. 069 (E-587) 03 März 1988, & JP-A-62 211940
- PATENT ABSTRACTS OF JAPAN vol. 12, no. 003 (E-570) 07 Januar 1988, & JP-A-62 165348
- PATENT ABSTRACTS OF JAPAN vol. 13, no. 240 (E-767) 06 Juni 1989, & JP-A 01 042825

## Beschreibung

Die Erfindung betrifft einen Lötverbinder gemäß dem Oberbegriff des Anspruches 1 und ein Verfahren zur Herstellung einer elektrischen Schaltung mit diesem Lötverbinder gemäß dem Oberbegriff des Anspruches 4.

In der Mikroelektronik ist die Methode der Drahtkontaktierung bei elektrischen Bauelementen sehr verbreitet. Bei der Drahtkontaktierung wird jeder Draht einzeln von einer Kontaktfläche des elektrischen Bauelementes zu einer Kontaktfläche eines Substrats gezogen. Unter Verwendung dünner Drähte, üblicherweise aus Gold oder Aluminium von 25 µm Durchmesser und unter Anwendung von Druck, Temperatur oder Ultraschall werden dabei Feinschweißverbindungen erzeugt. Die Drahtkontaktierung ermöglicht zwar ein automatisierbares und wirtschaftliches Fertigungsverfahren, die damit erzeugten elektrischen Verbindungen sind aber nicht besonders stabil. Aus Stabilitätsgründen wird deshalb oft die Kontaktierung in reiner Löttechnik der Drahtkontaktierung vorgezogen. Dabei wird die Lötbrücke von einem stabilen Kupferdraht gebildet, der mittels eines Lötkolbens mit den Kontaktflächen verlötet wird. Sind mehrere Kontaktflächen elektrischer Bauelemente miteinander oder mit Kontaktflächen des Substrats zu verbinden, so ist dieser Vorgang sehr zeitaufwendig und es können durch die Handlötung leicht mangelhafte Kontaktstellen entstehen.

Aus EP-A 0 303 808 ist ein Lötverbinder bekannt, bei dem mehrere Kupferdrähte als Lötbrücken voneinander beabstandet in einer gemeinsamen flexiblen Folie eingebettet sind. Durch Aufsetzen dieses Lötverbinders auf das Substrat werden viele Kontaktstellen ohne viel Aufwand überbrückt. Die Lötbrücken können stabil ausgebildet werden. Der Nachteil dieses bekannten Lötverbinders ist die aufwendige Herstellung der Hybrid-Struktur bestehend aus dem isolierenden Halter und den Lötbrücken. Der bekannte Lötverbinder findet in einem Verfahren zur Herstellung einer elektrischen Schaltung Verwendung, welches die in den Ansprüchen 5 und 6 enthaltenen zusätzlichen Merkmale aufweist.

Ein Lötverbinder gemäß dem Oberbegriff des Anspruchs 1 ist aus US-A-4 413 404 bekannt.

Der Erfindung liegt die Aufgabe zugrunde, einen Lötverbinder zu schaffen, in dem mehrere Lötbrücken integriert sind und der einfach sowie kostensparend herzustellen ist.

Diese Aufgabe wird erfindungsgemäß durch die Merkmale des Anspruches 1 gelöst.

Weiterhin liegt der Erfindung die Aufgabe zugrunde, ein Verfahren anzugeben, mit dem durch einfache Weise mehrere Kontaktflächen elektrischer Bauelemente miteinander oder mit Kontaktflächen eines Substrats überbrückt werden können. Die Lötbrücken sollen dabei einfach herstellbar sein, nicht viel Raum in Anspruch nehmen und trotzdem eine sichere und stabile elektrische Verbindung gewährleisten.

Diese weitere Aufgabe wird erfindungsgemäß durch die Merkmale des Anspruches 4 gelöst.

Die mit der Erfindung erzielten Vorteile bestehen insbesondere darin, daß sich der Lötverbinder preiswert herstellen läßt, da eine aufwendige Hybrid-Struktur nicht erforderlich ist. Der Lötvorgang kann für viele Lötstellen simultan im Durchlaufofen erfolgen. Durch Wegfall der Handlötung kann auf aggressive Flußmittel verzichtet werden und die Notwendigkeit einer anschließenden Platinen-Reinigung mit Lösungsmitteln entfällt somit. Die Lage der Lötbrücken ist exakt festgelegt und die Zufälligkeit der Handlötung mit ihren Risiken entfällt. Durch den flachen Aufbau der Lötbrücken und den guten Formschluß des Lotes sind die Lötstellen gegenüber Schock und Vibration wesentlich unempfindlicher als beim Stand der Technik.

Ausführungsbeispiele der Erfindung werden anhand der Zeichnungen näher erläutert.

Es zeigt
- Figur 1: einen schematisch dargestellten Lötverbinder in Draufsicht,
- Figur 2: eine vergrößerte Darstellung einer Lötbrücke nach Figur 1,
- Figur 3: eine vergrößerte Darstellung einer weiteren Variante einer Lötbrücke,
- Figur 4: eine perspektivische Darstellung einer elektrischen Schaltung mit dem Lötverbinder und
- Figur 5: einen Querschnitt durch eine Lötbrücke nach Figur 4.

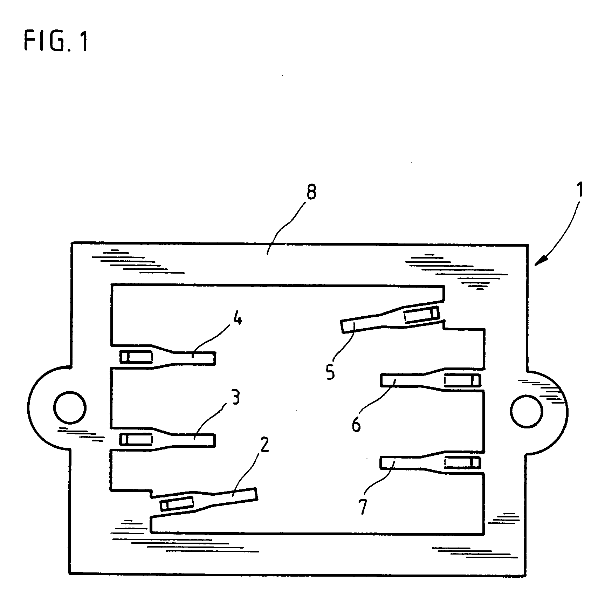

In Figur 1 ist ein Lötverbinder 1 in Draufsicht schematisch dargestellt. Der Lötverbinder 1 besteht aus mehreren Lötbrücken 2, 3, 4, 5, 6 und 7 und einem gemeinsamen umlaufenden Halter 8. Der Halter 8 mit den Lötbrücken 2 bis 7 ist aus elektrisch leitendem Material, vorzugsweise Kupfer hergestellt und ist einstückig sowie freitragend ausgebildet. Die Breite einer Lötbrücke 2 bis 7 beträgt etwa 0,5 mm, so daß sich zur Herstellung dieser freitragenden Mikrostrukturen das galvanoplastische Verfahren anbietet.

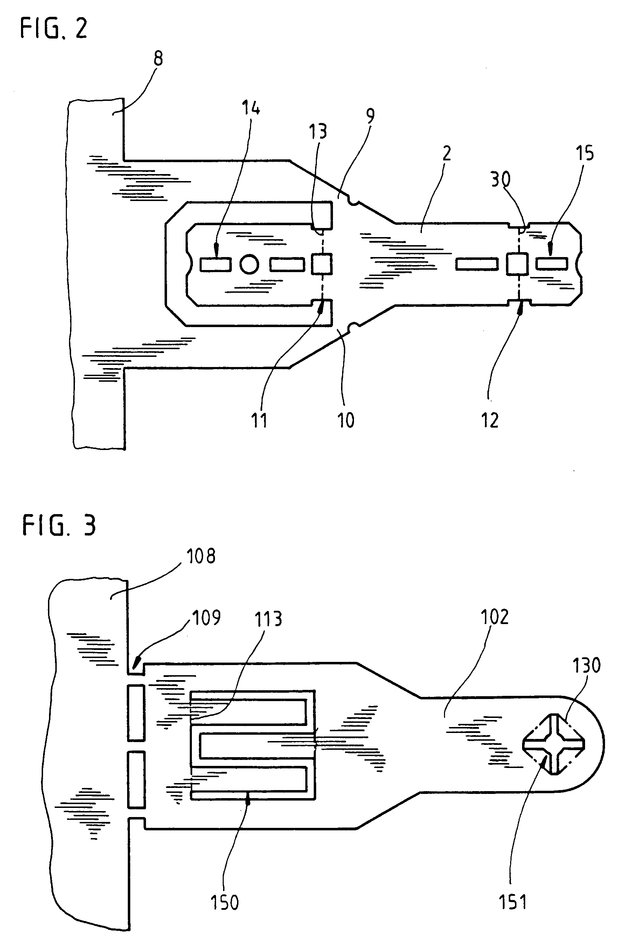

Eine vorteilhafte Ausbildung der Lötbrücken 2 bis 7 ist in der Figur 2 gezeigt. Die dargestellte Lötbrücke 2 ist mit dem Halter 8 über Sollbruchstellen 9, 10 verbunden. Die Sollbruchstellen 9, 10 dienen dazu, daß der Kalter 8 nach dem Lötvorgang leicht durch Abreißen von der Lötbrücke 2 getrennt werden kann. Die Lötbrücke 2 besitzt quer verlaufende Perforationen 11, 12, durch die Biegekanten 13, 30 lagemäßig vorgegeben sind. Es lassen sich so die Anforderungen an die Präzision und damit die Kosten der Biegewerkzeuge enorm reduzieren. Zum Niveau-Ausgleich erforderliche Biegungen und Kröpfungen der Lötbrücke 2 lassen sich einfach realisieren.

Die Enden der Lötbrücke 2 weisen ebenfalls Perforationen 14, 15 auf, die eine gute Lotaufnahme und einen durchdringenden Formschluß des Lotes garantieren. Diese Perforationen 14, 15 verlaufen zweckmäßigerweise längs der Lötbrücke 2. Durch die schlitzartige Ausführung der Perforationen 14, 15 wird eine Kapillarwirkung erreicht, so daß auch überschüssiges Lot und Flußmittel infolge der Oberflächenspannung von der Lötstelle entlang dieser Perforationen 14, 15 abgeführt wird.

Die Figur 3 zeigt eine weitere vergrößerte Darstellung einer Lötbrücke 102. Bei dieser Variante ist die Sollbruchstelle 109 direkt an der Innenkante des Halters 108 vorgesehen. Quer verlaufende Perforationen als Biegekanten sind bei diesem Ausführungsbeispiel nicht notwendig. Zum Niveauausgleich werden die Laschen 150, 151 umgebogen. Diese Laschen 150, 151 garantieren beim Lötvorgang einen durchdringenden Formschluß des Lotes mit der Lötbrücke 102. Die sich beim Biegevorgang ergebenden Biegekanten 113, 130 sind gestrichelt eingezeichnet.

Die im Detail gezeigten Lötbrücken 2 und 102 besitzen jeweils nur zwei Lötstellen. Bei Bedarf können pro Lötbrücke in nicht gezeigter Weise auch mehrere Lötstellen vorgesehen werden.

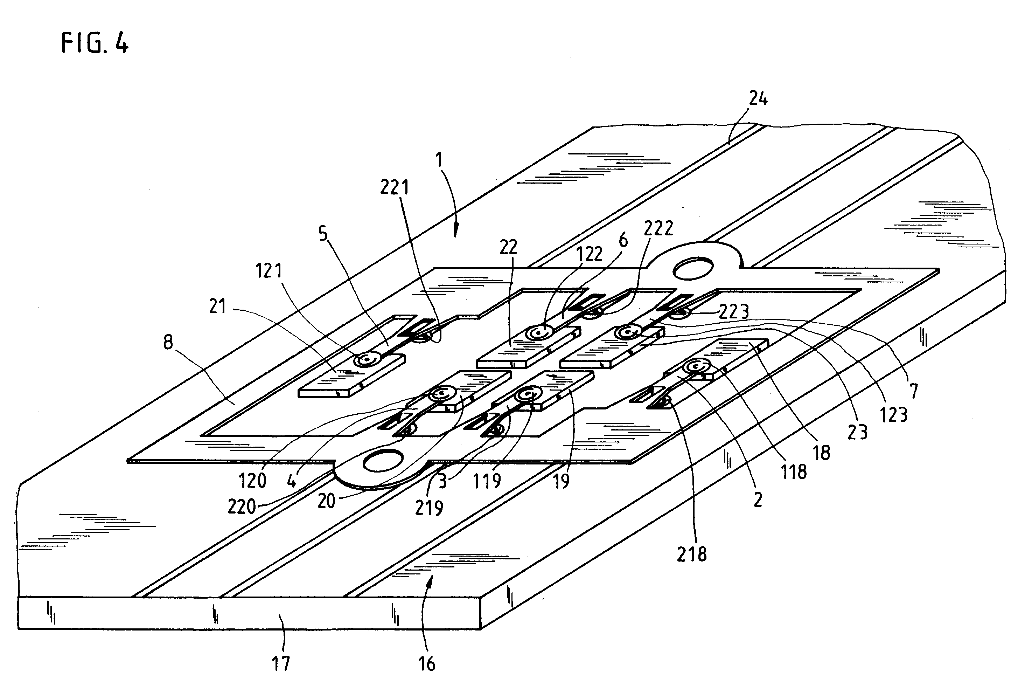

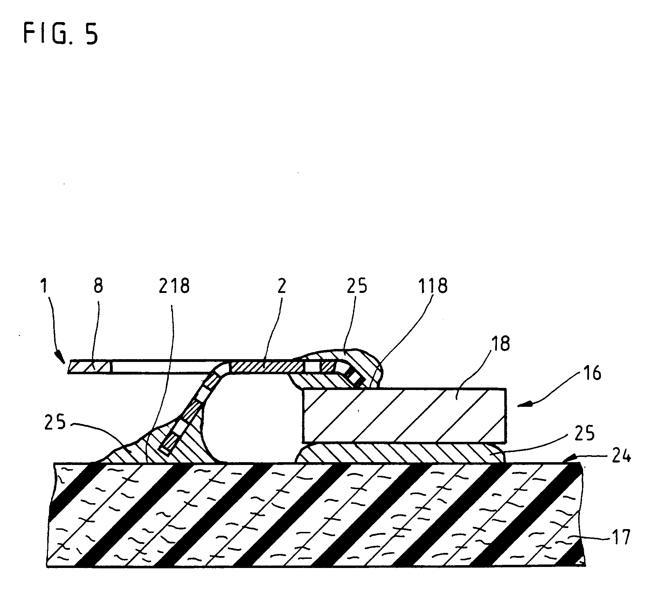

Um das Verfahren zur Herstellung einer elektrischen Schaltung 16 mit einem erfindungsgemäß ausgestalteten Lötverbinder 1 näher erläutern zu können, ist in den Figuren 4 und 5 eine bestückte Leiterplatte 17 gezeigt. Diese Leiterplatte 17 - auch als Substrat bezeichnet - ist Bestandteil einer Abtasteinheit einer inkrementalen, lichtelektrischen Positionsmeßeinrichtung. Bei derartigen Positionsmeßeinrichtungen kommen in zunehmendem Maße bei der Bestückung der Leiterplatten 17 oberflächenmontierte elektrische Bauelemente zur Anwendung. Die Bauelemente zur Abtastung der Maßverkörperung sind optoelektronische Halbleiterbauelemente in Form von Silizium-Fotoelementen 18, 19, 20, 21, 22 und 23.

In der Figur 4 sind wegen der Übersichtlichkeit nur die Fotoelemente 18 bis 23 gezeigt, selbstverständlich befinden sich auf der Leiterplatte 17 noch weitere elektrische Bauelemente.

Die metallisierte Rückseite der Fotoelemente 18 bis 23 ist mit der Leiterplatte 17 elektrisch leitend verbunden. Hierzu wird als erster Schritt eine gedruckte Schaltung 24 auf das Substrat 17 aufgebracht. Auf die so entstandene Leiterplatte 17 wird Lotpaste 25 als leitende Zwischenschicht an den Stellen aufgebracht, an denen die Fotoelemente 18 bis 23 zu positionieren sind. Nach dem Positionieren der Fotoelemente 18 bis 23 von Hand oder mit einem Bestückungsautomaten wird Lotpaste 25 auf die Kontaktflächen 118, 119, 120, 121, 122 und 123 auf der Oberseite der Fotoelemente 18 bis 23 aufgetragen. Im gleichen Verfahrensschritt kann auch die Lotpaste 25 auf die Kontaktflächen 218, 219, 220, 221, 222 und 223 aufgetragen werden.

Der vorgebogene Lötverbinder 1 wird nun so auf die Leiterplatte 17 aufgesetzt, daß jede Lötbrücke 2 bis 7 jeweils eine Kontaktfläche 118 bis 123 eines Fotoelementes 18 bis 23 und eine Kontaktfläche 218 bis 223 der gedruckten Schaltung 24 überbrückt. Nach dem Aufsetzen und Positionieren des Lötverbinders 1 erfolgt die Lötung, vorzugsweise Reflow-Lötung im Infrarot-Ofen. Die mechanische Festigkeit der so erzeugten Lötverbindungen ist sehr hoch und die Fotoelemente 18 bis 23 werden beim Reflow-Löten gleich hohen Temperaturen ausgesetzt. Weiterhin erfolgt eine selbsttätige Feinpositionierung der Fotoelemente 18 bis 23 und des Lötverbinders 1 durch Oberflächenspannungs-Effekte.

Nach dem Lötvorgang wird der gemeinsame Halter 8 entfernt, so daß vom Lötverbinder 1 nur noch die einzelnen Lötbrücken 2 bis 7 auf der Leiterplatte 17 verbleiben. Durch die Sollbruchstellen 9, 10 zwischen dem gemeinsamen Halter 8 und den einzelnen Lötbrücken 2 bis 7 kann der Halter 8 einfach durch Abreißen von den Lötbrücken 2 bis 7 abgetrennt werden, ohne die Lötbrücken 2 bis 7 zu beschädigen.

Mit dem erfindungsgemäßen Lötverbinder 1 können auch andere elektrische Schaltungen hergestellt werden. Die elektrischen Bauelemente müssen auch nicht Fotoelemente 18 bis 23 sein, es können auch Kontaktflächen anderer Bauelemente mit Kontaktflächen einer gedruckten Schaltung überbrückt werden. Weiterhin können auch Kontaktflächen mehrerer elektrischer Bauelemente miteinander oder Kontaktflächen einer gedruckten Schaltung mit einem Lötverbinder elektrisch miteinander verbunden und überbrückt werden.

## Patentansprüche

1. Lötverbinder (1) mit mehreren Lötbrücken (2, 3, 4, 5, 6, 7; 102), wobei jede Lötbrücke (2, 3, 4, 5, 6, 7; 102) über eine Sollbruchstelle (9, 10; 109) mit einem gemeinsamen Halter (8; 108) Verbunden ist und der Halter (8, 108) mit den Lötbrücken (2, 3, 4, 5, 6, 7; 102) aus elektrisch leitendem Material einstückig sowie freitragend ausgebildet ist, wobei ferner jede der Lötbrücken (2, 3, 4, 5, 6, 7; 102) mehrere Stellen aufweist, welche zur Lötung ausgebildet sind, und wobei nach erfolgter Lötung der Halter (8, 108) über die Sollbruchstellen (9, 10; 109) von den Lötbrücken (2, 3, 4, 5, 6, 7; 102) trennbar ist, dadurch gekennzeichnet, daß die Lötbrücken (2, 3, 4, 5, 6, 7; 102) Perforationen (z.B. 12, 13) besitzen, durch die Biegekanten (13, 30; 113, 130) lagemäßig vorgegeben sind, an denen die Lötbrücken (2, 3, 4, 5, 6, 7; 102) niveauausgleichende Biegungen zwischen dem Halter (8; 108) und den zur Lötung ausgebildeten Stellen aufweisen.

2. Lötverbinder nach Anspruch 1, dadurch gekennzeichnet, daß die Perforationen (12, 13), durch die die Biegekanten (13, 30) lagemäßig vorgegeben sind, als quer verlaufende Perforationen ausgebildet sind.

3. Lötverbinder nach Anspruch 1, dadurch gekennzeichnet, daß sich die zur Lötung ausgebildeten Stellen an den Enden der Lötbrücken (2, 3, 4, 5, 6, 7) befinden und dort Perforationen (14, 15) zur Lotaufnahme und zur Abfuhr des überschüssigen Flußmittels vorgesehen sind, welche schlitzartig ausgebildet sind und längs der Lötbrücken (2, 3, 4, 5, 6, 7) verlaufen.

4. Verfahren zur Herstellung einer elektrischen Schaltung (16) unter Verwendung eines Lötverbinders (1) nach einem der Ansprüche 1 bis 3, gekennzeichnet durch folgende Verfahrensschritte:
a) Aufsetzen des Vorgebogenen Lötverbinders (1) auf ein Substrat (17) mit elektrisch zu verbindenden Kontaktflächen (118, 218; 119, 219; 120, 220; 121, 221; 122, 222; 123, 223), so daß jede Lötbrücke (2, 3, 4, 5, 6, 7) zumindest zwei Kontaktflächen (118, 218; 119, 219; 120, 220; 121, 221; 122, 222; 123, 223) überbrückt, wobei die an den Lötbrücken (2, 3, 4, 5, 6, 7) ausgebildeten Biegungen einen Niveauausgleich zwischen dem Halter (8) und den Kontaktflächen (118, 218; 119, 219; 120, 220; 121, 221; 122, 222; 123, 223) herstellen;
b) Lötung der Lötbrücken (2, 3, 4, 5, 6, 7) mit den Kontaktflächen (118, 218; 119, 219; 120, 220; 121, 221; 122, 222; 123, 223);
c) Entfernen des gemeinsamen Halters (8) durch Abtrennen des Halters (8) an den zwischen ihm und den Lötbrücken (2, 3, 4, 5, 6, 7) vorgesehenen Sollbruchstellen (9, 10).

5. Verfahren nach Anspruch 4, dadurch gekennzeichnet, daß vor dem Aufsetzen des Lötverbinders (1) Lotpaste (25) auf die Kontaktflächen (118, 119, 120, 121, 122, 123; 218, 219, 220, 221, 222, 223) aufgetragen wird, und daß die Lötung mittels Reflow-Lötung erfolgt.

6. Verfahren nach Anspruch 4 oder 5, dadurch gekennzeichnet, daß die elektrische Schaltung (16) Bestandteil einer lichtelektrischen Positionsmeßeinrichtung ist, und daß als Substrat (17) eine eine gedruckte Schaltung (24) aufweisende Leiterplatte verwendet wird, die mit oberflächen montierten Fotoelementen (18, 19, 20, 21, 22, 23) bestückt wird, deren oben liegende Kontaktflächen (118, 119, 120, 121, 122, 123) mit Kontaktflächen (218, 219, 220, 221, 222, 223) der gedruckten Schaltung (24) mittels des Lötverbinders (1) elektrisch verbunden werden.

## Claims

1. Solder connector (1) with a plurality of solder bridges (2, 3, 4, 5, 6, 7; 102), each solder bridge (2, 3, 4, 5, 6, 7; 102) being connected via a predetermined breaking point (9, 10; 109) to a common holder (8; 108), and the holder (8, 108) is integrally and unsupportedly formed from electrically conductive material, each of the solder bridges (2, 3, 4, 5, 6, 7; 102) further having a plurality of points designed for soldering, the holder (8, 108), after soldering, being separable from the solder bridges (2, 3, 4, 5, 6, 7; 102) by means of the predetermined breaking points (9, 10; 109), characterised in that the solder bridges (2, 3, 4, 5, 6, 7; 102) have perforations (e.g. 12, 13) by means of which bending edges (13, 30; 113, 130) are positionally predetermined, on which the solder bridges (2, 3, 4, 5, 6, 7; 102) have level-equalising bends between the holder (8; 108) and the points designed for soldering.

2. Solder connector according to claim 1, characterised in that the perforations (12, 13), by means of which the bending edges (13, 30) are positionally predetermined, are in the form of transversely-extending perforations.

3. Solder connector according to claim 1, characterised in that the points designed for soldering are located at the ends of the solder bridges (2, 3, 4, 5, 6, 7), and at that point perforations (14, 15) are provided for receiving the solder and for removal of the excess flux, said perforations being slot-shaped and extending along the solder bridges (2, 3, 4, 5, 6, 7).

4. Method of manufacturing an electrical circuit (16), using a solder connector (1) according to one of claims 1 to 3, characterised by the following process steps:
a) Mounting of the previously-bent solder connector (1) on a substrate (17) with contact surfaces (118, 218; 119, 219; 120, 220; 121, 221; 122, 222; 123, 223) to be electrically connected, so that each solder bridge (2, 3, 4, 5, 6, 7) overlaps at least two contact surfaces (118, 218; 119, 219; 120, 220; 121, 221; 122, 222; 123, 223), the bends formed at the solder bridges (2, 3, 4, 5, 6, 7) forming a level equalisation between the holder (8) and the contact surfaces (118, 218; 119, 219; 120, 220; 121, 221; 122, 221; 123, 223);
b) Soldering the solder bridges (2, 3, 4, 5, 6, 7) to the contact surfaces (118, 218; 119, 219; 120, 220; 121, 221; 122, 222; 123, 223) ;
c) removal of the common holder (8) by separating the holder (8) at the predetermined breaking points (9, 10) provided between that point and the solder bridges (2, 3, 4, 5, 6, 7).

5. Method according to claim 4, characterised in that, before the solder connector (1) is mounted, solder paste (25) is applied to the contact surfaces (118, 119, 120, 121, 122, 123; 218, 219, 220, 221, 222, 223), and in that soldering is effected by reflux soldering.

6. Method according to claim 4 or 5, characterised in that the electrical circuit (16) is a component of a photoelectric position measuring device, and in that there is used as a substrate (17) a printed-circuit board having a printed circuit (24), said printed circuit board being fitted with surface-mounted photoelectric elements (18, 19, 20, 21, 22, 23), whose upwardly-lying contact surfaces (118, 218; 119, 219; 120, 220; 121, 221; 122, 221; 123, 223) are electrically connected to contact surfaces (218, 219, 220, 221, 222, 223) of the printed circuit (24) by means of the solder connector (1).

## Revendications

1. Connecteur à souder (1) comportant plusieurs éléments de pontage (2, 3 4, 5, 6, 7; 102) à souder, chaque élément de pontage à souder (2, 3 4, 5, 6, 7; 102) étant lié par un point destiné à la rupture (9, 10; 109) à un support (8; 108) commun et le support (8; 108) étant agencé sous forme d'élément monobloc, autoportant, en matériau électro-conducteur, chacun des éléments de pontage (2, 3 4, 5, 6, 7; 102) à souder présentant plusieurs points qui sont agencés pour le soudage et le support (8; 108) pouvant être séparé des éléments de pontage (2, 3 4, 5, 6, 7; 102) à souder au niveau des points destinés à la rupture (9, 10; 109) après réalisation de la soudure, caractérisé par le fait que les éléments de pontage (2, 3 4, 5, 6, 7; 102) à souder comportent des perforations (par exemple 12, 13) qui déterminent la position d'arêtes de pliage (13, 30; 113, 130) au niveau desquelles les éléments de pontage (2, 3 4, 5, 6, 7; 102) sont pourvus de pliures permettant de rattraper la différence de niveau entre le support (8; 108) et les points destinés à la soudure.

2. Connecteur selon la revendication 1, caractérisé par le fait que les perforations (12, 13) qui prédéterminent les arêtes de pliage (13, 30) sont agencées sous forme de perforations s'étendant dans la direction transversale.

3. Connecteur selon la revendication 1, caractérisé par le fait que les emplacements agencés pour le soudage sont situés aux extrémités des éléments de pontage (2, 3 4, 5, 6, 7) à souder et qu'il est prévu à cet endroit des perforations (14, 15) destinées à recevoir la soudure et à évacuer l'excédent de flux décapant, lesquelles perforations sont agencées sous forme de fente et s'étendent le long des élément de pontage (2, 3 4, 5, 6, 7) à souder.

4. Procédé de réalisation d'un circuit électrique (16) en utitisant un connecteur à souder (1) selon l'une des revendications 1 à 3, caractérisé par les étapes suivantes:
a) mise en place du connecteur à souder (1) préplié sur un substrat (17) comportant des surfaces de contact (118, 218; 119, 219; 120, 220; 121, 221; 122, 222; 123, 223) de telle sorte que chaque élément de pontage (2, 3 4, 5, 6, 7) à souder relie au moins deux surfaces de contact (118, 218; 119, 219; 120, 220; 121, 221; 122, 222; 123, 223), les pliures formées sur les éléments de pontage (2, 3, 4, 5, 6, 7) rattrapant la différence de niveau entre le support (8) et les surfaces de contact (118, 218; 119, 219; 120, 220; 121, 221; 122, 222; 123, 223);
b) soudage des éléments de pontage (2, 3, 4, 5, 6, 7) avec les surfaces de contact (118, 218; 119, 219; 120, 220; 121, 221; 122, 222; 123, 223);
c) élimination du support (8) commun par séparation du support (8) au niveau des points destinés à la rupture (9, 10) prévus entre celui-ci et les éléments de pontage (2, 3, 4, 5, 6, 7) à souder.

5. Procédé selon la revendication 4, caractérisé par le fait que, avant de mettre en place le connecteur à souder (1), on applique de la pâte à braser (25) sur les surfaces de contact (118, 218; 119, 219; 120, 220; 121, 221; 122, 222; 123, 223) et par le fait qu'on réalise la soudure par soudage par refusion.

6. Procédé selon la revendication 4 ou 5, caractérisé par le fait que le circuit électrique (16) fait partie d'un dispositif photo-électrique de mesure de position et par le fait que l'on utilise comme substrat (17) une carte imprimée qui comporte un circuit imprimé (24) avec, montées sur sa surface, des cellules photo-électriques (18, 19, 20, 21, 22, 23) dont les surfaces de contact (118, 119, 120, 121, 122, 123) supérieures sont connectées électriquement par l'intermédiaire du connecteur à souder (1) à des surfaces de contact (218, 219, 220, 221, 222, 223) du circuit imprimé (24).
